(19) Europäisches Patentamt

European Patent Office

Office européen des brevets

(11) **EP 1 475 663 A2**

(12) **EUROPÄISCHE PATENTANMELDUNG**

(43) Veröffentlichungstag:
   **10.11.2004   Patentblatt 2004/46**

(51) Int Cl.⁷: **G03F 1/14**

(21) Anmeldenummer: **04008830.4**

(22) Anmeldetag: **15.04.2004**

(84) Benannte Vertragsstaaten:
   **AT BE BG CH CY CZ DE DK EE ES FI FR GB GR HU IE IT LI LU MC NL PL PT RO SE SI SK TR**
   Benannte Erstreckungsstaaten:
   **AL HR LT LV MK**

(30) Priorität: **16.04.2003  DE 10317792**

(71) Anmelder:
   • **Schott Glas**
     **55122 Mainz (DE)**
     Benannte Vertragsstaaten:
     **AT BE BG CH LI CY CZ DE DK EE ES FI FR GR HU IT LU MC NL PL PT RO SE SI SK TR**
   • **CARL-ZEISS-STIFTUNG**
     **trading as SCHOTT GLAS**
     **55122 Mainz (DE)**
     Benannte Vertragsstaaten:
     **IE GB**

(72) Erfinder:
   • **Aschke, Lutz**
     **55129 Mainz (DE)**
   • **Renno, Markus, Dipl.-Phys.**
     **98617 Meiningen (DE)**
   • **Schiffler, Mario, Dipl.-Ing.**
     **98634 Oepfershausen (DE)**
   • **Sobel, Frank, Dr.**
     **98617 Meiningen (DE)**
   • **Becker, Hans, Dr.**
     **98617 Meiningen (DE)**

(74) Vertreter: **Patentanwälte Kewitz & Kollegen Partnerschaft**
   **Corneliusstrasse 18**
   **60325 Frankfurt am Main (DE)**

(54) **Maskenrohling zur Verwendung in der EUV-Lithographie und Verfahren zu dessen Herstellung**

(57)   Die Erfindung betrifft einen Maskenrohling (mask blank) zur Verwendung in der EUV-Lithographie und ein Verfahren zu dessen Herstellung.

Der Maskenrohling umfasst ein Substrat mit einer Vorderseite und einer Rückseite, wobei auf der Vorderseite eine Beschichtung zur Verwendung als Maske in der EUV-Lithographie aufgebracht ist und die Rückseite eine elektrisch leitfähige Beschichtung aufweist. Die elektrisch leitfähige Beschichtung ist gemäß DIN 58196-5, DIN 58196-4 und DIN 58196-6 besonders abriebsfest und haftbeständig und zeichnet sich durch eine elektrische Mindestleitfähigkeit aus. Das Substrat besteht aus einem Nullausdehnungsmaterial. Die elektrisch leitfähige Beschichtung wird mittels eines Ionenstrahl-gestützten Sputterns aufgebracht.

Weil die elektrisch leitfähige Rückseitenbeschichtung so abriebsfest und haftbeständig ist, kann der Maskenrohling mit Hilfe einer elektrostatischen Haltevorrichtung (chuck) ergriffen, gehalten und gehandhabt werden, ohne dass es zu einem störenden Abrieb kommt.

**Beschreibung**

Die vorliegende Erfindung betrifft einen Maskenrohling (mask blank) zur Verwendung in der EUV-Lithographie sowie ein Verfahren zu dessen Herstellung.

Zur Erzielung immer größerer Integrationsdichten in der Mikroelektronik müssen immer kürzere Wellenlängen zur Belichtung verwendet werden. Es ist absehbar, dass zukünftig Wellenlängen von nur noch 13 Nanometer oder gar darunter verwendet werden, um Strukturen von unter 35 Nanometer herzustellen. Dabei kommt der Herstellung von Masken zur Belichtung in der Lithographie eine Schlüsselrolle zu. Die Masken müssen praktisch fehlerfrei hergestellt werden, weil sich sonst geringste Fehler auf der Maske auf jedem Chip wieder finden. Sämtliche Quellen, die zu einer Kontamination der Maske führen können, müssen weitestgehend ausgeschlossen werden.

Dies erfordert sehr präzise Techniken zur Herstellung von Maskenrohlingen und eine sehr sorgfältige Halterung und Handhabung der Maskenrohlinge, um einen Abrieb und eine Partikelbildung weitestgehend zu vermeiden. Auch geringfügige Verbesserungen solcher Verfahren hinsichtlich des Risikos von Kontaminierungen des Maskenrohlings können zu erheblichen Verbesserungen der Qualität bei der Halbleiterfertigung führen. Deshalb darf es nicht verwundern, wenn auch relativ aufwändige und kostspielige Verfahren zur Herstellung und Handhabung von Maskenrohlingen grundsätzlich in Betracht kommen können. Denn Ziel ist es in der Halbleiterfertigung stets, eine möglichst hohe Integrationsdichte bei möglichst kleiner Ausschussquote zu erzielen.

Aufgabe der vorliegenden Erfindung ist es, einen Maskenrohling zur Verwendung in der EUV-Lithographie zu schaffen, mit dem das Risiko von Kontaminationen und Maskenfehlern noch weiter verringert werden kann. Ferner soll gemäß der vorliegenden Erfindung ein Verfahren zur Herstellung eines solchen Maskenrohlings geschaffen werden.

Diese Aufgabe wird gelöst durch einen Maskenrohling mit den Merkmalen nach Anspruch 1 sowie durch ein Verfahren zu dessen Herstellung nach Anspruch 10. Vorteilhafte weitere Ausführungsformen sind Gegenstand der rückbezogenen Unteransprüche.

Gemäß der vorliegenden Erfindung wird ein Maskenrohling zur Verwendung in der EUV-Lithographie geschaffen, wobei der Maskenrohling ein Substrat mit einer Vorderseite und einer Rückseite umfasst und auf der Vorderseite eine Beschichtung zur Verwendung als Maske in der EUV-Lithographie aufgebracht ist. Gemäß der vorliegenden Erfindung weist die Rückseite des Substrats eine elektrisch leitfähige Beschichtung auf. Somit kann ein Maskenrohling mit einer überraschend einfachen Auslegung bereitgestellt werden, der Vorteile hinsichtlich des Risikos von Kontaminationen und Partikelbildung aufweist. Erfindungsgemäß besteht das Substrat bevorzugt aus einem Nullausdehnungsmaterial.

Denn ein erfindungsgemäß hergestellter Maskenrohling kann mit Hilfe einer elektrostatischen Haltevorrichtung (elektrostatic chuck) rückseitig und großflächig gehalten werden. Wegen der großflächigen Berührung von elektrostatischer Haltevorrichtung und Rückseite des Substrats bedarf es nur geringer Haltekräfte. Diese führen ihrerseits zu einem geringeren Abrieb und somit zu einem geringeren Risiko von Kontaminationen. Außerdem kann ein erfindungsgemäßer Maskenrohling sehr schonend gehalten und gehandhabt werden. Ein elektrisches Potenzial, das an die elektrostatische Haltevorrichtung und/oder an die Rückseite des Maskenrohlings angelegt wird, kann vorteilhaft kontrolliert und schonend an- und ausgeschaltet werden. Dadurch lassen sich ruckartige Krafteinwirkungen auf den Maskenrohling weitestgehend vermeiden, was zu einem noch geringeren Abrieb und einer noch geringeren Partikelbildung führt. Der großflächige Kontakt von Maskenrohling und elektrostatischer Haltevorrichtung kann auch dazu verwendet werden, um den Maskenrohling gerade zu ziehen, beispielsweise wenn er verbogen oder verspannt ist, um so Spannungen zu verringern.

Bevorzugt fällt die Beständigkeit der elektrisch leitfähigen Beschichtung gegen Abrieb mit einem Tuch gemäß DIN 58196-5 zumindest in die Kategorie 2. Selbst wenn der Maskenrohling bzw. eine daraus gefertigte Maske in der Halbleiterfertigung von Hand oder mit Hilfe von Handlingswerkzeugen ergriffen werden sollte, beispielsweise während Austausch- oder Wartungsarbeiten, oder wenn dieser bzw. diese für weitere Prozessschritte gehalten werden soll, fällt somit praktisch kein Abrieb an, weil die Beschichtung der Rückseite so abriebfest ist.

Bevorzugt fällt die Beständigkeit der elektrisch leitfähigen Beschichtung gegen Abrieb mit einem Radiergummi gemäß DIN 58196-4 zumindest in die Kategorie 2. Selbst wenn der Maskenrohling bzw. eine daraus gefertigte Maske in der Halbleiterfertigung streifend berührt oder ergriffen werden sollte, beispielsweise von Hand oder von einem Werkzeug, oder wenn dieser bzw. diese für weitere Prozessschritte gehalten werden soll, fällt erfindungsgemäß praktisch keine Abrieb an, weil die elektrisch leitfähige Beschichtung auf der Rückseite so abriebfest ist.

Bevorzugt entspricht die Haftfestigkeit der leitfähigen Beschichtung bei einer Prüfung mit Hilfe eines Klebebands gemäß DIN 58196-6 einer Ablösung von im wesentlichen 0%. Selbst wenn einmal ein klebriger Gegenstand mit einem Maskenrohling oder einer daraus hergestellten Maske in Berührung geraten sollte, beispielsweise während Austausch- oder Wartungsarbeiten, wird praktisch kein Teil der elektrisch leitfähigen Beschichtung auf der Rückseite abgelöst, was sonst zu Kontaminationen und störendem Abrieb führen würde. Insgesamt lässt sich also festhalten, dass der erfindungsgemäße Maskenrohling oder eine daraus hergestellte Maske vorteilhaft zuverlässig und wartungsfreundlich gehandhabt werden kann.

Bevorzugt besteht das Substrat aus einem Nullausdehnungsmaterial, das beispielsweise ein modifiziertes Quarzglas oder eine modifizierte Glaskeramik sein kann. Unter dem Begriff Nullausdehnungsmaterial sei in dieser Patentanmeldung ein Material verstanden, das in dem bestimmungsgemäßen Temperaturbereich keine signifikante, jedenfalls keine große thermische Ausdehnung zeigt. Bevorzugt hat das Nullausdehnungsmaterial in dem Temperaturbereich von etwa 0 bis 50 Grad Celsius eine thermische Ausdehnung von weniger als etwa $\pm$100 ppb/K, bevorzugter von weniger als etwa $\pm$30 ppb/K und noch bevorzugter von weniger als etwa $\pm$5 ppb/K, weil sich in den genannten Bereichen Maskenrohlinge mit besonders vorteilhaften Eigenschaften herstellen lassen, insbesondere was die Verwendung bei einem lithographischen Belichtungsverfahren und die Abriebsfestigkeit der aufgebrachten Schichten anbelangt.

Zu den Eigenschaften von gemäß der vorliegenden Erfindung bevorzugt verwendeten Nullausdehnungsmaterialien sei beispielhaft auf die folgenden Anmeldungen verwiesen, deren Inhalt hiermit ausdrücklich im Wege der Bezugnahme in diese Anmeldung mit aufgenommen sei: DE-OS-19 02 432, US 4,851,372, US 5,591,682 sowie DE 101 63 597.4.

Als Nullausdehnungsmaterial kann auch Corning® 7971 verwendet werden, das ein ULE-Material (ultra low expansion) ist, bestehend aus Titansilikatglas (92,5% Si02 und 7,5% Ti02). Zur Herstellung werden reines flüssiges Siliziumtetrachlorid und Titantetrachlorid miteinander vermischt und werden Dämpfe davon einem Schmelzofen zugeführt, wo diese chemisch miteinander reagieren. Glaströpfchen scheiden sich auf einem rotierenden Drehtisch ab, wobei es ca. eine Woche benötigt, um einen Rohling mit einem Durchmesser von etwa 170 cm und einer Dicke von etwa 15cm herzustellen. Die so erhaltene Glaszusammensetzung zeichnet sich durch einen extrem niedrigen Temperaturausdehnungskoeffizienten aus.

Zur Erzielung ausreichender optischer Eigenschaften ist zumindest auf die Vorderseite des Maskenrohlings eine Beschichtung aufgebracht, die ein System von dielektrischen Doppelschichten, insbesondere von Molybdän-Silizium-Doppelschichten, und eine Chrom-Schicht oder eine andere EUV-absorbierende Schicht umfasst. Somit kann ein Maskenrohling mit einer überraschend hohen Abriebsfestigkeit bereitgestellt werden, der in der EUV-Lithographie verwendbar ist, insbesondere bei Wellenlängen bis hinab zu etwa 13 Nanometer.

Bevorzugt sind die dielektrischen Doppelschichten durch Ionenstrahl gestützte Deposition, insbesondere durch Ionenstrahl gestütztes Sputtern, aufgebracht, was zu sehr homogenen und defektfreien Schichten führt und somit für eine hohe Reflektivität der Beschichtung sorgt. Insgesamt lassen sich somit sehr präzise Abbildungsoptiken und Masken bereitstellen. Bezüglich des Beschichtungsverfahrens sei auf die ebenfalls anhängige US-Patentanmeldung serial no. 10/367,539 der Anmelderin mit dem Titel 'Photo Mask Blank, Photo Mask, Method and Apparatus for Manufacturing of a Photo Mask Blank' mit Anmeldetag vom 13. Februar 2003 verwiesen, deren Inhalt hiermit im Wege der Bezugnahme ausdrücklich in dieser Anmeldung mit aufgenommen sei.

Ein Maskenrohling kann in überraschend einfacher Weise dadurch bereitgestellt werden, dass die Vorderseite und die Rückseite eine im Wesentlichen identische oder abschnittsweise identische Beschichtung aufweisen. Somit lassen sich identische Beschichtungstechniken und Prozessschritte sowohl für die Vorderseite als auch für die Rückseite des Maskenrohlings verwenden. Dies spart Zeit bei deren Herstellung und verringert die Gefahr von Kontaminationen, weil Prozesskammern oder dergleichen, worin der Maskenrohling beschichtet wird, nicht unbedingt geöffnet werden müssen und der Maskenrohling nicht unbedingt in eine andere Prozesskammer überführt werden muss. Vielmehr kann der Maskenrohling in ein und derselben Prozesskammer vorderseitig und rückseitig beschichtet oder abschnittsweise beschichtet werden.

Damit der Maskenrohling noch zuverlässiger von einer elektrostatischen Haltevorrichtung ergriffen und gehalten werden kann, beträgt der spezifische Widerstand der elektrisch leitfähigen Beschichtung bei einer Schichtdicke von etwa 100 nm zumindest etwa $10^{-3}$ $\Omega$ cm, bevorzugter zumindest etwa $10^{-4}$ $\Omega$ cm, weil sich der Maskenrohling so noch besser halten und greifen lässt, noch bevorzugter zumindest etwa $10^{-5}$ $\Omega$ cm, weil sich der Maskenrohling so noch besser halten und greifen lässt, noch bevorzugter zumindest etwa $10^{-6}$ $\Omega$ cm, weil sich der Maskenrohling so noch besser halten und greifen lässt, noch bevorzugter zumindest etwa $10^{-7}$ $\Omega$ cm, weil sich der Maskenrohling so noch besser halten und greifen lässt und noch bevorzugter zumindest etwa $10^{-8}$ $\Omega$ cm, weil sich der Maskenrohling so noch besser halten und greifen lässt. Als ganz besonders bevorzugt hat sich insbesondere auch ein spezifischer Widerstand bei einer Schichtdicke von etwa 100 nm von zumindest etwa $10^{-5}$ $\Omega$ cm erwiesen.

Gemäß der vorliegenden Erfindung wird auch ein Verfahren zur Herstellung eines Maskenrohlings zur Verwendung in der EUV-Lithographie bereitgestellt, wobei der Maskenrohling ein Substrat aus einem Nullausdehnungsmaterial mit einer Vorderseite und einer Rückseite umfasst, bei welchem Verfahren auf die Vorderseite eine Beschichtung zur Verwendung als Maske in der EUV-Lithographie aufgebracht wird und auf die Rückseite eine elektrisch leitfähige Beschichtung aufgebracht wird.

Nachfolgend werden bevorzugte Ausführungsbeispiele gemäß der vorliegenden Erfindung in beispielhafter Weise beschrieben werden. Beim Studium der nachfolgenden Ausführungsbeispiele werden dem Fachmann weitere Merkmale, Vorteile und Modifikationen gemäß der vorliegenden Erfindung ersichtlich werden.

Der Maskenrohling gemäß der vorliegenden Erfindung umfasst ein Substrat, das aus einem hochhomogen optischen Glas, aus Quarzglas, aus einer Glaskeramik oder aus einem vergleichbaren Werkstoff besteht. Hinsichtlich der Wärmeausdehnung ist das Substrat vorzugsweise praktisch ein Nullausdehnungsmaterial. Der Maskenrohling ist bevorzugt rechteckförmig ausgebildet, beispielsweise mit einer Kantenlänge von ca. 15 cm. Selbstverständlich kann der Maskenrohling auch eine andere geometrische Form aufweisen, beispielsweise kreisrund sein. Das Substrat wird poliert, mit einer Genauigkeit von nur wenigen Zehntel Nanometer. Wie aus dem Stand der Technik bekannt ist, ist auf der Vorderseite ein System von dielektrischen Doppelschichten ausgebildet, die die Braggsche Reflexionsbedingung zur Verstärkung von reflektierter Strahlung durch konstruktive Interferenz erfüllen. Ein Beispiel für eine belichtende Wellenlänge von 13,4 Nanometer gemäß der vorliegenden Erfindung umfasst etwa 50 Molybdän-Silizium-Doppelschichten, mit einer Schichtdicke des Molybdäns von etwa 2,8 Nanometer und einer Schichtdicke des Siliziums von etwa 4 Nanometer. Geeignete dielektrische Vielschichtsysteme, in Anpassung an die jeweils bei der Belichtung verwendete Wellenlänge, sind dem Fachmann bekannt.

Auf die Oberfläche des dielektrischen Vielschichtsystems ist eine Metallmaske, insbesondere eine Chrom-Maske oder ein anderer EUV-Absorber, aufgebracht, um die belichtende Strahlung zu absorbieren. Die Metall-Schicht, insbesondere die Chrom-Schicht, ist bevorzugt strukturiert. Die Vorderseite des Substrats ist bevorzugt insgesamt elektrisch leitfähig.

Gemäß der vorliegenden Erfindung ist auch auf die Rückseite des Substrats eine elektrisch leitfähige Beschichtung aufgebracht. Diese ist vorzugsweise auf die gesamte Oberfläche der Rückseite aufgebracht, kann jedoch auch in geeigneter Weise abschnittsweise auf der Rückseite aufgebracht sein, beispielsweise ringförmig, quadratisch, beispielsweise in Anpassung an die Außenkontur einer verwendeten elektrostatischen Haltevorrichtung (electrostatic chuck).

Bevorzugt wird die elektrisch leitfähige Beschichtung auf der Rückseite des Substrats mit Hilfe von identischen Prozessschritten, die zur Herstellung der entsprechenden elektrisch leitfähigen Beschichtung auf der Vorderseite des Substrats dienen, aufgebracht. Somit kann der Maskenrohling zumindest abschnittsweise in ein und demselben Arbeitsschritt hergestellt werden. Dies kann es überflüssig machen, in einer Abscheidekammer eine Schutzgasatmosphäre oder ein Vakuum aufzubrechen. Selbstverständlich kann auch auf der Rückseite des Substrats eine dielektrische Vielfachbeschichtung aufgebracht sein, die bevorzugt identisch zur der auf der Vorderseite des Substrats ausgebildeten Vielfachbeschichtung ist.

Substrat und Beschichtungen sind für Belichtungswellenlängen im ultravioletten Spektralbereich ausgelegt, zur Verwendung in der EUV-Lithographie (extreme ultraviolet lithographie). Zukünftig angedacht in der EUV-Lithographie ist die Verwendung von Wellenlängen bis hinab zu etwa 13 Nanometer.

Die Beschichtungen auf der Vorderseite des Maskenrohlings (mask blank) sind zunächst unstrukturiert. In einem nachfolgenden Prozessschritt, der entweder beim Hersteller des Maskenrohlings oder beim Abnehmer des Maskenrohlings ausgeführt werden kann, werden die Beschichtungen geeignet strukturiert, so dass eine Maske zur EUV-Lithographie bereitgestellt werden kann. Maskenrohling oder Maske können mit einer Lackschicht überzogen sein, beispielsweise aus einem Photolack (photoresist) oder einem Schutzlack.

Weil die Rückseite des Substrats elektrisch leitfähig beschichtet ist, kann der Maskenrohling mit Hilfe einer elektrostatischen Haltevorrichtung gehalten und gehandhabt werden. Aufgrund der elektrisch leitfähigen Beschichtung auf der Rückseite des Maskenrohlings können auch elektrostatische Aufladungen des Maskenrohlings, beispielsweise beim Transport oder während der Handhabung, noch wirkungsvoller vermieden werden.

Zur Beschichtung der Rückseite des Substrats kommen grundsätzlich sämtliche Metallisierungstechniken, die eine ausreichende Qualität der Metallisierung gewährleisten, in Frage. Als besonders geeignet hat sich eine Ionenstrahl gestützte Deposition, insbesondere ein Ionenstrahl gestüztes Sputtern, erwiesen. Bei dieser Beschichtungstechnik wird ein Ionenstrahl auf ein Target gelenkt, dessen Material sich in ein Vakuum hinein ablöst. Das Target befindet sich in der Nähe zu dem zu beschichtenden Substrat und wird mit der abgelösten Target-Substanz durch Sputtern beschichtet. Wenngleich dieses Beschichtungsverfahren relativ aufwendig und kostspielig ist, hat es sich zur Beschichtung von Masken oder Maskenrohlingen als besonders geeignet erwiesen, weil die aufgebrachten Schichten besonders homogen und fehlerfrei sind. Mit der Ionenstrahl gestützten Deposition kann ein Metall oder eine Mischung aus zwei oder mehr Metallen oder Dielektrika aufgebracht werden. Bezüglich der Einzelheiten der Ionenstrahl gestützten Deposition von Metallen und Dielektrika sei auf die ebenfalls anhängige US-Patentanmeldung serial no. 10/367,539 der Anmelderin mit dem Titel ‚Photo Mask Blank, Photo Mask, Method and Apparatus for Manufacturing of a Photo Mask Blank' mit Anmeldetag vom 13. Februar 2003 verwiesen, deren Inhalt hiermit im Wege der Bezugnahme ausdrücklich in dieser Anmeldung mit aufgenommen sei.

Die so auf die Rückseite des Substrats aufgebrachten elektrisch leitfähigen Beschichtungen zeichnen sich durch eine Reihe von vorteilhaften Eigenschaften aus, insbesondere hinsichtlich Abrieb und Beständigkeit, die nachfolgend anhand von bevorzugten Ausführungsbeispielen, die in relativ aufwändigen Versuchsreihen hergestellt und charakterisiert wurden, beschrieben werden.

**Ausführungsbeispiel 1**

Auf die Rückseite eines Maskenrohlings wird mittels Ionenstrahl gestütztem Sputtern eine Chrom-Schicht aufgebracht, die eine Dicke von etwa 50 Nanometer bis etwa 100 Nanometer aufweist. Die Beständigkeit der Beschichtung auf der Rückseite gegen Abrieb mit einem Tuch wird in Anlehnung an DIN 58196-5 beurteilt. Gemäß DIN 58196-5 wird die Probe entsprechend dem festgelegten Schärfegrad (H25: Anzahl Zyklen 25; H50: Anzahl Zyklen 50) beansprucht. Ein Stempel mit planer Auflagefläche von 10 mm Durchmesser, über den ein Tuch aus 4-lagiger Mullbinde nach DIN 61631 - MB - 12 CV/CO gespannt ist, wird mit einer Kraft von 4,5 N wenigstens mit 20 mm langen Hub-Schubbewegungen (ein Zyklus) über die Probenoberfläche geführt.

Nach der Beanspruchung wird die Probe mit Watte und Lösemittel nach DIN 58752 gereinigt. Die Fläche wird unter verschiedenen Winkeln unter Drehen und Kippen der Probe im Licht einer 100-W-Klarglas-Glühlampe in Reflexion und Transmission ohne vergrößernde Hilfsmittel in einer Box vor mattschwarzem Hintergrund visuell beurteilt. Der Abstand Lampe-Probe sollte etwa 30 bis 40 cm betragen, der Abstand Probe-Auge etwa 25 cm.

Die Auswertung gemäß DIN 58196-6 erfolgt durch Bewertung der visuell sichtbaren Schichtzerstörung. Die Zuordnung des Ergebnisses erfolgt zu einer der fünf in der Norm definierten Beständigkeitsklassen. Die ermittelten Beständigkeitsklassen können zur Bewertung der Schichthaftung genutzt werden. Gemäß DIN 58196-5 sind in der Kategorie 1 keinerlei Beschädigungen der Schicht sichtbar, ist in der Kategorie 2 leichtes Streulicht aufgrund von Abriebspuren erkennbar, ist in der Kategorie 3 stärkeres Streulicht erkennbar, wobei eine beginnende partielle Schädigung schwach erkennbar ist, sind in der Kategorie 4 partielle Beschädigungen der Schicht deutlich erkennbar und ist in der Kategorie 5 nach dem Abrieb die Beschichtung bis auf das Substrat abgetragen.

Das vorgenannte Substrat wird gemäß DIN 58196-5 beurteilt. Die Anzahl von Hüben beträgt 25 (Schärfegrad H25). Es wurden 20 Proben beurteilt. Alle Proben wurden gemäß DIN 58196-5 mit der Kategorie 2 oder besser gewertet.

**Ausführungsbeispiel 2**

Ein Maskenrohling, wie er im Zusammenhang mit dem Ausführungsbeispiel 1 beschrieben worden ist, wird in Anlehnung an DIN 58196-4 auf Beständigkeit der Rückseitenbeschichtung gegen Abrieb mit einem Radiergummi gerieben. DIN 58196-4 beschreibt im Detail die Präparation der Oberfläche des verwendeten Radiergummis (Aufrauhen an einer Mattglasscheibe, Reinigen mit Isopropanol) und die Durchführung der Prüfung (Durchmesser der Reibfläche 6,5 - 7 mm, Reibkraft 4,5 N, Reibweg 20 mm). Der Radiergummi wird über die Rückseitenbeschichtung gerieben. Die Auswertung erfolgt durch subjektive Bewertung der visuell sichtbaren Schichtzerstörung. Die Zuordnung des Ergebnisses erfolgt zu einer der fünf nachfolgend definierten Beständigkeitsklassen gemäß DIN 58196-5. Die ermittelten Beständigkeitsklassen können zur Bewertung der Schichthaftung genutzt werden.

Gemäß Kategorie 1 sind keinerlei Beschädigungen der Schicht erkennbar, ist gemäß der Kategorie 2 leichtes Streulicht erkennbar, so dass die Abriebsspur als solche erkennbar ist, ist gemäß der Kategorie 3 stärkeres Streulicht erkennbar, so dass eine beginnende partielle Schädigung der Rückseitenbeschichtung schwach erkennbar ist, sind gemäß der Kategorie 4 partielle Schädigungen der Rückseitenbeschichtung deutlich erkennbar und ist gemäß der Kategorie 5 die Rückseitenbeschichtung bis auf das Substrat abgetragen.

Bewertet wurden 20 Proben, wobei der Radiergummi 20 mal auf der Rückseitenbeschichtung gerieben wurde. Alle Proben wurden mit der Kategorie 2 oder besser bewertet.

**Ausführungsbeispiel 3**

Ein Maskenrohling, wie er im Zusammenhang mit dem Ausführungsbeispiel 1 ausführlich beschrieben wurde, wird mit Hilfe eines Prüfverfahrens nach DIN 58196-6 (Prüfung der Haftfestigkeit mit einem Klebeband) hinsichtlich der Haftfestigkeit der Rückseitenbeschichtung bewertet. Gemäß DIN 58196-6 wird die Probe flach auf eine feststehende Unterlage (Tisch) gelegt. Dann wird ein frischer Streifen von einer Klebebandrolle mindestens 25 mm lang durch Aufdrücken mit dem Finger blasenfrei über die Kante hinweg auf die zu prüfende Fläche geklebt. Das Klebeband sollte aus Polyester bestehen und wenigstens 12 mm breit sein. Seine Klebekraft muss $(9,8 \pm 0,5)$N, bezogen auf eine Bandbreite von 25 mm, betragen. Nach 1 Minute wird das überstehende Ende des Streifens genommen, und er wird mit einer Hand senkrecht zur Prüffläche abgezogen, während die andere Hand die Probe fest auf der Unterlage hält. Je nach Schärfegrad wird das Klebeband langsam - in 2 bis 3 Sekunden (Schärfegrad K1) oder ruckartig - in weniger als 1 Sekunde (Schärfegrad K2) - abgezogen. Die Auswertung erfolgt durch subjektive Bewertung visuell sichtbarer Schichtzerstörungen, die durch einen Prozentsatz der Ablösung durch die abgeklebte Fläche ausgedrückt werden.

Bewertet wurden 20 Proben. Das Klebeband wurde ruckartig, innerhalb von weniger als einer Sekunde, abgezogen (Schärfegrad K2). Alle Proben zeigen eine Ablösung von etwa 0 Prozent.

**Ausführungsbeispiel 4**

Ein Maskenrohling, wie er vorstehend im Zusammenhang mit dem Ausführungsbeispiel 1 beschrieben wurde, wurde mit zwei Flächenwiderstandsmethoden gemessen. Folgende Flächenwiderstände ergeben sich in der Mitte der Scheibe. Es sind pro Strom immer zwei Messungen ausgeführt worden.

|  | Lineare van der Pauw-Methode | | Lineare Vierspitzenmethode | |
|---|---|---|---|---|
| Strom [mA] | Rf [Ohm] | + - | Rf [Ohm] | + - |
| 1 | 26.2056 | 0.0108 | 26.1019 | 0.0028 |
| 2 | 26.2186 | 0.0051 | 26.0941 | 0.0002 |
| 3 | 26.2218 | 0.0061 | 26.0705 | 0.0003 |
| 4 | 26.2140 | 0.0030 | 26.0765 | 0.0001 |
| 5 | 26.2142 | 0.0023 | 26.0788 | 0.0005 |
| Durchschnitt | **26.2148** | **0.0060** | **26.0844** | **0.0130** |

Mit noch kleinerem Strom von 0,5 mA wurden ausgehend vom Mittelpunkt noch 1 cm abweichend vom Mittelpunkt die folgenden Werte des Flächenwiderstandes in Ohm gemessen:

| 26.2866 | | 26.2703 |
|---|---|---|
| | 26.2728 | |
| 26.3068 | | 26.2520 |

Zur Berechnung des spezifischen Widerstands der Schicht muss der Flächenwiderstand mit der Schichtdicke multipliziert werden, bei z. B. 40 nm Schichtdicke ergibt sich somit beispielsweise:

$$26,2728 \text{ Ohm} * 40 \text{ nm} = 105\mu\text{Ohmcm}.$$

Entsprechend lässt sich auch die elektrische Leitfähigkeit der Rückseitenbeschichtung berechnen.

Bei den vorgenannten Ausführungsbeispielen können die aufgesputterten Chrom-Schichten oder EUV-absorbierenden Schichten selbstverständlich auch andere Dicken aufweisen, beispielsweise im Bereich von etwa 30 nm bis etwa 100 nm, bevorzugter im Bereich von etwa 40 nm bis etwa 90 nm und noch bevorzugter im Bereich von etwa 50 nm bis etwa 70 nm.

Es sei ausdrücklich darauf hingewiesen, dass die Spezifikationen der DIN 51896 hiermit im Wege der Bezugnahme ausdrücklich mit in dieser Patentanmeldung mit aufgenommen seien, insbesondere was die dort vorgeschriebenen Prüfverfahren und Bewertungen anbelangt.

**Patentansprüche**

1. Maskenrohling zur Verwendung in der EUV-Lithographie, umfassend ein Substrat mit einer Vorderseite und einer Rückseite, wobei auf der Vorderseite eine Beschichtung zur Verwendung als Maske in der EUV-Lithographie aufgebracht ist, **dadurch gekennzeichnet, dass** die Rückseite eine elektrisch leitfähige Beschichtung aufweist.

2. Maskenrohling nach Anspruch 1, wobei das Substrat aus einem Nullausdehnungsmaterial besteht.

3. Maskenrohling nach einem der vorhergehenden Ansprüche, **dadurch gekennzeichnet, dass** der spezifische Widerstand der elektrisch leitfähigen Beschichtung bei einer Schichtdicke von etwa 100 nm zumindest etwa $10^{-7}$ $\Omega$ cm, noch bevorzugter zumindest etwa $10^{-6}$ $\Omega$ cm und noch bevorzugter zumindest etwa $10^{-5}$ $\Omega$ cm beträgt.

4. Maskenrohling nach einem der vorhergehenden Ansprüche, **dadurch gekennzeichnet, dass** die Beständigkeit der elektrisch leitfähigen Beschichtung gegen Abrieb mit einem Tuch gemäß DIN 58196-5 zumindest in die Kategorie zwei fällt.

5. Maskenrohling nach einem der vorhergehenden Ansprüche, **dadurch gekennzeichnet, dass** die Beständigkeit der elektrisch leitfähigen Beschichtung gegen Abrieb mit einem Radiergummi gemäß DIN 58196-4 zumindest in die Kategorie zwei fällt.

6. Maskenrohling nach einem der vorhergehenden Ansprüche, **dadurch gekennzeichnet, dass** die Haftfestigkeit der elektrisch leitfähigen Beschichtung bei einer Prüfung mit Hilfe eines Klebebands gemäß DIN 58196-6 einer Ablösung von im Wesentlichen 0% entspricht.

7. Maskenrohling nach einem der vorhergehenden Ansprüche, **dadurch gekennzeichnet, dass** das Substrat aus einem Quarzglas oder einer Glaskeramik besteht.

8. Maskenrohling nach einem der vorhergehenden Ansprüche, **dadurch gekennzeichnet, dass** zumindest auf die Vorderseite eine Beschichtung aufgebracht ist, die ein System von dielektrischen Doppelschichten, insbesondere von Mo/Si-Doppelschichten, und eine Chrom-Schicht oder eine EUV-absorbierende Schicht umfasst, wobei die dielektrischen Doppelschichten durch Ionenstrahl gestützte Deposition, insbesondere Ionenstrahl gestütztes Sputtern, aufgebracht sind.

9. Maskenrohling nach einem der vorhergehenden Ansprüche, **dadurch gekennzeichnet, dass** die Vorderseite und die Rückseite eine im Wesentlichen identische Beschichtung aufweisen.

10. Verfahren zum Beschichten eines Maskenrohlings zur Verwendung in der EUV-Lithographie, der ein Substrat mit einer Vorderseite und einer Rückseite umfasst, bei welchem Verfahren auf die Vorderseite eine Beschichtung zur Verwendung als Maske in der EUV-Lithographie aufgebracht wird und auf die Rückseite eine elektrisch leitfähige Beschichtung aufgebracht wird.

11. Verfahren nach Anspruch 10, wobei das Substrat als Substrat, das aus einem Nullausdehnungsmaterial besteht, bereitgestellt wird.

12. Verfahren nach einem der Ansprüche 10 oder 11, bei dem die elektrisch leitfähige Beschichtung so aufgebracht wird, dass der spezifische Widerstand der elektrisch leitfähigen Beschichtung bei einer Schichtdicke von etwa 100 nm zumindest etwa $10^{-7}$ Ω cm, noch bevorzugter zumindest etwa $10^{-6}$ Ω cm und noch bevorzugter zumindest etwa $10^{-5}$ Ω cm beträgt.

13. Verfahren nach einem der Ansprüche 10 bis 12, wobei die leitfähige Beschichtung so aufgebracht wird, dass die Beständigkeit der elektrisch leitfähigen Beschichtung gegen Abrieb mit einem Tuch gemäß DIN 58196-5 zumindest in die Kategorie zwei fällt.

14. Verfahren nach einem der Ansprüche 10 bis 13, wobei die leitfähige Beschichtung so aufgebracht wird, dass die Beständigkeit der elektrisch leitfähigen Beschichtung gegen Abrieb mit einem Radiergummi gemäß DIN 58196-4 zumindest in die Kategorie zwei fällt.

15. Verfahren nach einem der Ansprüche 10 bis 14, wobei die leitfähige Beschichtung so aufgebracht wird, dass die Haftfestigkeit der elektrisch leitfähigen Beschichtung bei einer Prüfung mit Hilfe eines Klebebands gemäß DIN 58196-6 einer Ablösung von im Wesentlichen 0% entspricht.

16. Verfahren nach einem der Ansprüche 10 bis 15, bei dem zumindest auf die Vorderseite eine Beschichtung aufgebracht wird, die ein System von dielektrischen Doppelschichten, insbesondere von Mo/Si-Doppelschichten, und eine Chrom-Schicht oder eine EUV-absorbierende Schicht umfasst, wobei die dielektrischen Doppelschichten durch Ionenstrahl gestützte Deposition, insbesondere durch Ionenstrahl gestüztes Sputtern, aufgebracht werden.

17. Verfahren nach einem der Ansprüche 10 bis 16, bei dem die Vorderseite und die Rückseite im Wesentlichen identisch beschichtet werden.